Europäisches Patentamt

(19) European Patent Office

Office européen des brevets

(11) Publication number: **0 124 096**
**A2**

(12) # EUROPEAN PATENT APPLICATION

(21) Application number: **84104725.1**

(22) Date of filing: **26.04.84**

(51) Int. Cl.³: **G 01 N 24/08**

(30) Priority: **30.04.83 JP 76425/83**

(43) Date of publication of application: **07.11.84**
Bulletin 84/45

(84) Designated Contracting States: **DE FR GB**

(71) Applicant: **Kabushiki Kaisha Toshiba, 72, Horikawa-cho Saiwai-ku, Kawasaki-shi Kanagawa-ken 210 (JP)**

(72) Inventor: **Muto, Yasuhiro c/o Patent Division, K.K. Toshiba 1-1 Shibaura 1-chome, Minato-ku Tokyo 105 (JP)**

(74) Representative: **Patentanwälte Henkel, Pfenning, Feiler, Hänzel & Meinig, Möhlstrasse 37, D-8000 München 80 (DE)**

(54) Apparatus for measuring a nuclear magnetic resonance signal.

(57) An apparatus (100) for measuring an NMR signal includes at least a $H_O$ power supply (2), a power supply (4) for a gradient magnetic field ($G_Z$), and a pulse generator (5) for generating 90° and 180° exciting pulses. The gradient magnetic field ($G_Z$) is simultaneously applied to a slice of an object under investigation together with the 90° exciting pulse in conjunction with the static magnetic field ($H_O$). Then the 180° exciting pulse is applied to the excited slice of the object. Immediately after this application of the 180° pulse, the gradient magnetic field ($G_Z$) is again aplied to the slice thereof, so that the echo signal is measured.

EP 0 124 096 A2

- 1 -

## Apparatus for measuring a nuclear magnetic resonance signal

The present invention relates to an apparatus for measuring a nuclear magnetic resonance signal (NMR signal) that is produced in an object under investigation by a nuclear magnetic resonance phenomenon.

It is known from, for example U.S. Patent 4,254,778 issued on March 10, 1981 to Clow, an NMR apparatus, e.g., an NMR-CT (computerized tomography) diagnostic apparatus that the image data containing the proton density and the spin relaxation time is acquired by means of the NMR phenomenon occurred in the object, e.g., a patient.

An NMR-CT diagnostic apparatus provides as an image data about a specific nucleus and relaxation time in a given sectional plane of an object, e.g., a biological body, for medical purposes. In this case, the plane has a predetermined thickness and is called a slice, as in the case of an X-ray CT apparatus. Similarly, the width of the plane is called a width of a slice, and the position of the plane is called a slice position. A selective exciting method is known as a method for determining the width of a slice and the slice position. According to this selective exciting method, a predetermined gradient magnetic field is applied to a given slice in a direction perpendicular to the slice in conjunction with the static magnetic field while an excitation pulse including a frequency component required for obtaining a desired width of a slice is applied, thereby causing the NMR phenomenon in the given slice. A specific nucleus in the given slice is excited by this selective excitation. Due to the effect of the gradient magnetic field applied for determining the slice, even after the gradient magnetic field ceases to be applied, the nuclei in the slice are subject to the gyroscopic precession at different phases although they are spinning at the same frequency. When such a phase difference is present, a detected free induction decay signal (to be referred to as an FID signal hereinafter) as one type of NMR signals is attenuated, and the finally obtained image quality is degraded.

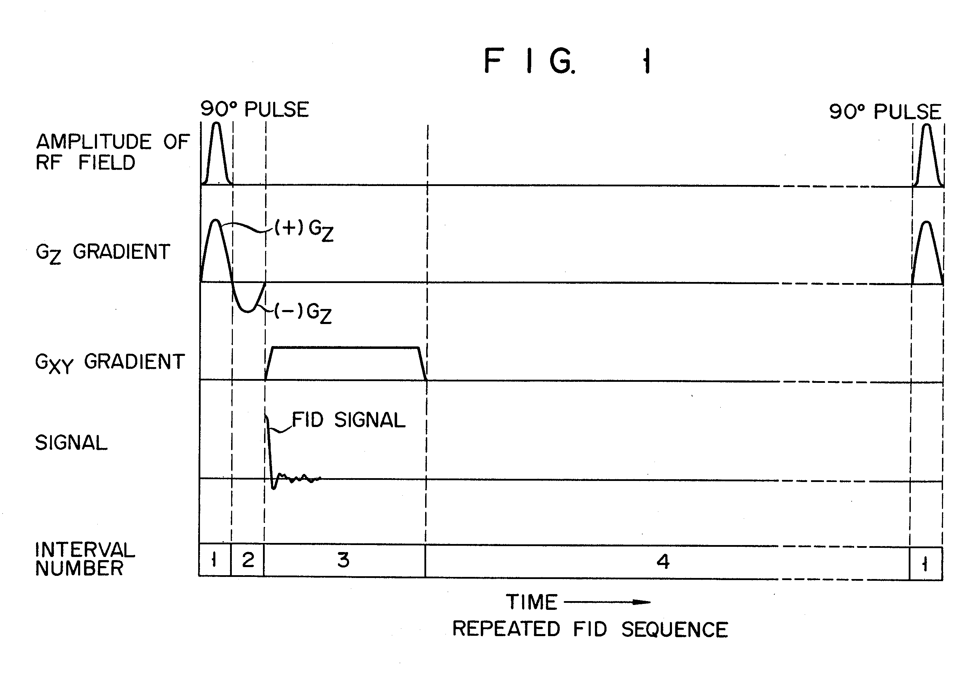

As a conventional method for obtaining an FID signal having a large amplitude by eliminating the phase difference of the gyroscopic precession of the nucleus, a method is known wherein a magnetic gradient field of the opposite polarity to that of a gradient magnetic field for determining a slice is applied after this slice is determined but before an NMR signal is collected. This method is generally adopted in conventional NMR-CT apparatus. For example, Figs. 1 to 3 show pulse sequences reported in "Initial Clinical Evaluation of a Whole Body Nuclear Magnetic Resonance (NMR) Tomograph (Journal of Computer Assisted Tomography 6(1): 1 - 18, February, 1982". The pulse sequences shown in Figs. 1 to 3 are mainly used for obtaining the typical image data in an NMR-CT apparatus, i.e., the nucleus density, T1 (spin-lattice relaxation time) data, and T2 (spin-spin relaxation time) data. In each case, after a slice is determined in the manner described above, a gradient magnetic field $(-)G_z$ of the opposite polarity to that of a gradient magnetic field $(+)G_z$ used in determining the slice is applied. Note that the longitudinal axis of an object (not shown) is designated as the Z-axis, and a slice perpendicular to this axis is defined by X- and Y-axes. It is well known in the field of NMR-CT apparatus to apply a gradient magnetic field $-G_Z$ of the opposite polarity as described above in order to eliminate the phase difference of the gyroscopic precession of the nucleus ordinarily caused upon determination of the slice.

The method of compensating the phase difference in the gyroscopic precession as described above will be described in more detail below.

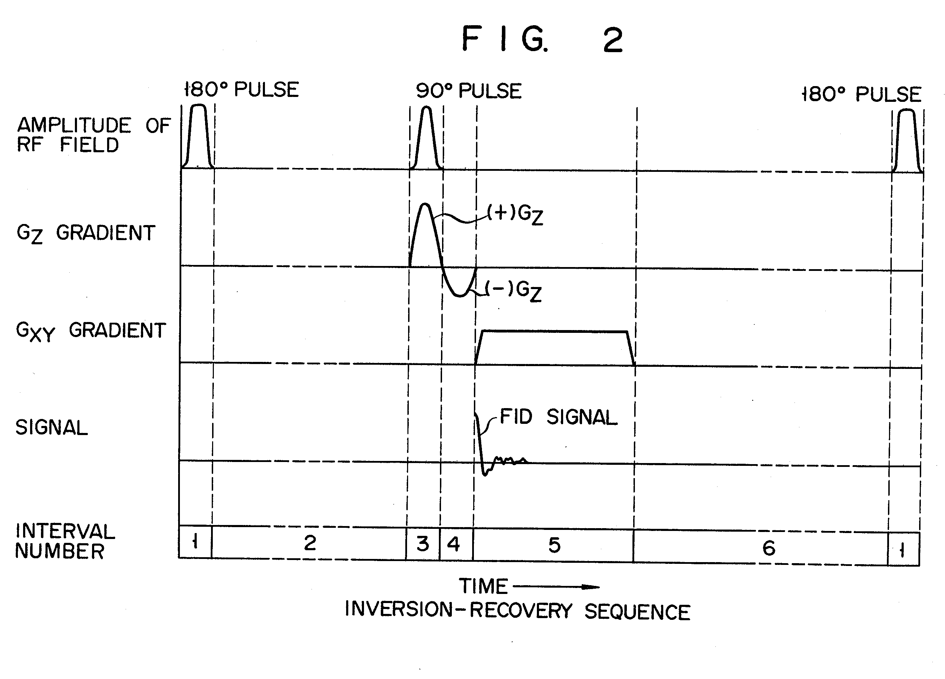

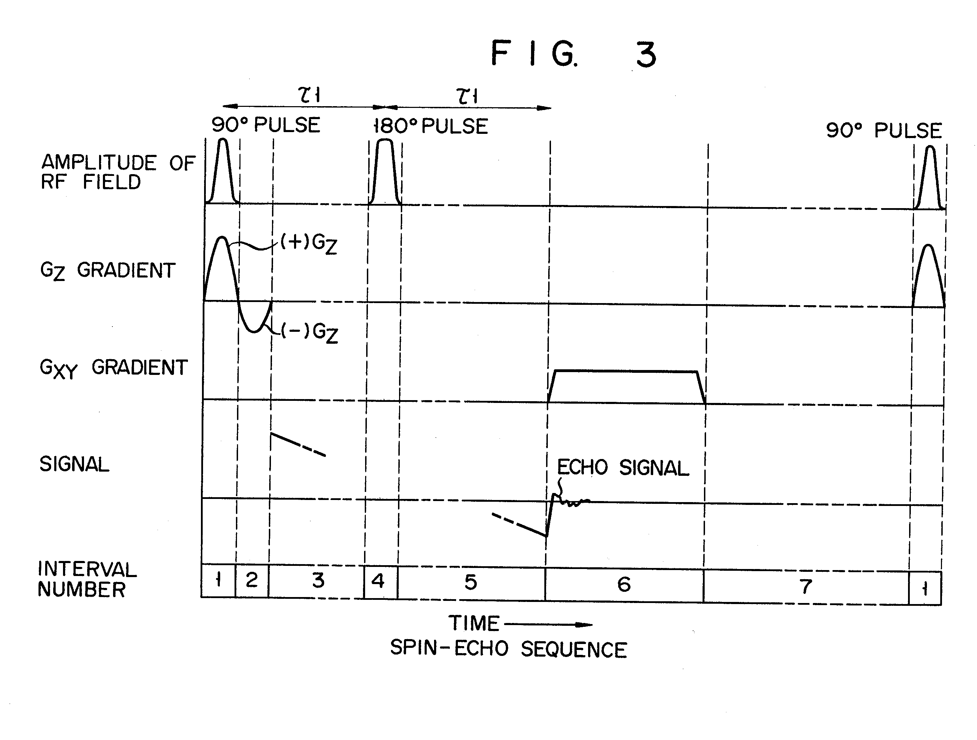

Fig. 1 shows a pulse sequence mainly for visually providing an image of the nucleus density data in the repeated FID method. Fig. 2 shows a pulse sequence mainly for visually providing an image of the relaxation time T1 distribution data in the inversion-recovery method. Fig. 3 shows a pulse sequence mainly for visually providing an image of the relaxation time T2 distribution data in the spin-echo method. Figs. 1 to 3 also show the application timings of an RF (radio frequency) pulse or RF spinning magnetic field such as a 90° pulse or a 180° pulse, a gradient magnetic field $G_Z$ for determining a slice (an X-Y plane defined by orthogonal X- and Y-axes), a gradient magnetic field $G_{XY}$ of the direction along the slice for determining the projection direction of an NMR signal, and an NMR signal such as an FID signal or an echo signal. These signal data are collected while a static field $H_0$ is being applied.

In the repeated FID method and the inversion-recovery method shown in Figs. 1 and 2, respectively, the FID signal is directly detected. However, in the spin-echo method shown in Fig. 3, the FID signal is observed indirectly as an echo signal. In Fig. 3, "$\tau_1$" denotes a time period between applications of the 90° and 180° pulses. The echo signal appears after the time period "$\tau_1$" has passed since the 180° pulse is applied.

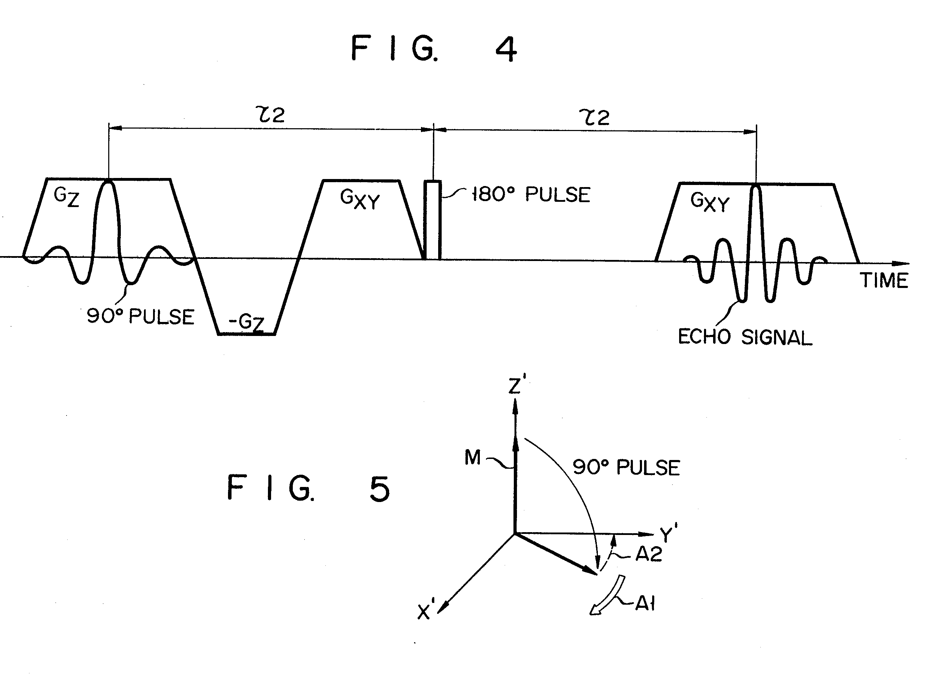

Fig. 4 shows another pulse sequence for observing the NMR signal as an echo signal as in the case shown in Fig. 3. In the case of Fig. 4, a 180° pulse is applied after the gradient magnetic field $G_{XY}$ is applied. In the methods shown in Figs. 3 and 4, after a 90° pulse is applied (and in the case shown in Fig. 4, a gradient field $G_{XY}$ is applied thereafter), a 180° pulse is applied and then the gradient magnetic field $G_{XY}$ is applied so as to obtain an echo signal. When the time interval between the applications of the 90° pulse and the 180° pulse is designated by "$\tau_2$" in the pulse sequence in Fig. 4, the echo signal takes a maximum value after time "$\tau_2$" following the application of the 180° pulse. In the methods shown in Figs. 3 and 4, the gradient magnetic field $G_Z$ and the 90° pulse are applied simultaneously (interval number 1 in Fig. 2) to perform the selective excitation. Thereafter, the gradient magnetic field $-G_Z$ of the opposite polarity is applied. Thus, the phase difference in the gyroscopic precession described above is cancelled.

The macrosopic magnetization vector "M" associated with this phase difference cancellation will be described with reference to Fig. 5. The coordinate system shown in Fig. 5 is a system which is rotated at a resonance angular frequency $\omega_0$ given by:

$$\omega_0 = \gamma H_0$$

(where $\gamma$ is the gyromagnetic ratio and $H_0$ is the intensity of a static field). The Z'-axis is along the direction of the static field $H_0$ and the X'-axis is along the direction of the excitation pulse. Upon application of a 90° pulse, the macroscopic magnetic vector "M" which has been directed along the Z'-axis is then directed along the Y'-axis. However, due to the gradient magnetic field $G_Z$ applied simultaneously with the 90° pulse, as shown in the interval number 1 in Fig. 1, the magnetization vector "M" is subject to gyroscopic precession at an angular frequency larger

than the frequency $\omega_0$ at a portion subject to a stronger magnetic field than the static field $H_0$. Therefore, at this portion, the magnetization vector M is shifted from the Y'-axis in the direction indicated by arrow A1. When the gradient magnetic field $-G_Z$ of the opposite polarity to that of the field $G_Z$ is applied thereafter (interval number 2), the magnetization vector "M" is shifted along the direction indicated by arrow A2 due to a magnetic field which is weaker than the magnetic field $H_0$. Therefore, when the application time of the gradient magnetic field $-G_Z$, i.e., the interval time period, is suitably selected, the vector "M" can be redirected along the Y'-axis. At another portion subjected to a weaker magnetic field than the magnetic field $H_0$ upon application of the gradient magnetic field $G_Z$, the magnetization vector "M" is shifted in the direction indicated by arrow A2 opposite to that indicated by the arrow A1 to be included in an X'-Y' plane. However, upon subsequent application of the gradient field $-G_Z$, the vector "M" can be shifted, in the direction indicated by the arrow A1 to be redirected along the Y'-axis.

The conventional method for cancelling the phase difference in the gyrosopic precession in the determination of the slice by means of application of a gradient magnetic field $-G_Z$ of the opposite polarity has the following problems.

(1) Cancelling precision by gradient magnetic field "$-G_Z$"

The cancelling precision in cancelling the phase difference by an applicaton of the gradient magnetic field $-G_Z$ of the opposite polarity is degraded unless the linearity of the gradient field $+G_Z$ applied for determining the slice coincides with that of the gradient field $-G_Z$ of the opposite polarity. The linearity is understood as a slope of (i.e., a slope of the gradient field $+G_Z$ relative to the intensity vs. the position corresponding to that of the gradient field $-G_Z$). For example, when a two-channel power supply is used for supplying power for generating the magnetic fields having both polarities (symmetrical polarities), a difference in the rise characteristics of the two channels results in a degradation in the cancelling precision and degradation in the image quality.

(2) Shim coil matter

When the gradient magnetic field coil also serves as a uniformity correction coil for the static magnetic field, a DC bias is normally applied. Therefore, the polarity inversion of the gradient magnetic field must be precisely performed in conjunction with the DC bias value.

Thus, with the method in which the polarity of the gradient magnetic field is reversed, a two-channel power supply, a switching circuit and the like are required. This results in a complex hardware construction, intensive maintenance of the hardware components, and complexity in software for controlling these hardware components.

It is therefore an object of the present invention to compensate by simple circuit arrangements in a stable condition, the phase difference in the gyroscopic precession of the nucleus occurred when the slice position is determined by the gradient magnetic field.

The object and the features of the present invention may be realized by providing an apparatus for measuring a nuclear magnetic resonance signal that is produced in an object under investigation by an NMR phenomenon, comprising:

means for applying uniformly a static magnetic field to an object under investigation;

means for applying at least a first gradient magnetic field to the object in a direction perpendicular to a slice of the object so as to determine a slice position of the object;

signal transmitter means through which first and second exciting pulses are selectively applied to the object so as to excite the slice of the object in conjunction with the static and first gradient magnetic fields, whereby the nuclear magnetic resonance signal is induced in the slice of the object;

signal receiver means through which the nuclear magnetic resonance signal is received; and

sequence control means for performing sequence control operations of at least the means for applying the first gradient magnetic field, and the signal transmitter means in such a manner that after the first exciting pulse and the first gradient magnetic field are simultaneously applied to excite and determine the slice of the object under the influence of the static magnetic field, another gradient magnetic field having the same polarity as that of the first gradient magnetic field is applied to the slice of the object immediately after the second exciting pulse is applied thereto.

According to the present invention, an apparatus for measuring an NMR signal can stably and easily correct the phase difference in the gyroscopic precession of the nucleus which occurs upon determination of a slice, and an NMR-CT apparatus can provide an image of good quality by means of a simple circuit configuration and a simple control procedure.

The invention is best understood by reference to the accompanying drawings, of which:

Figs. 1 to 4 show conventional pulse sequence diagrams how to acquire the FID signal and echo signal;

Fig. 5 is a schematical illustration for explaining the macromatic magnetization vector with respect to Fig. 4;

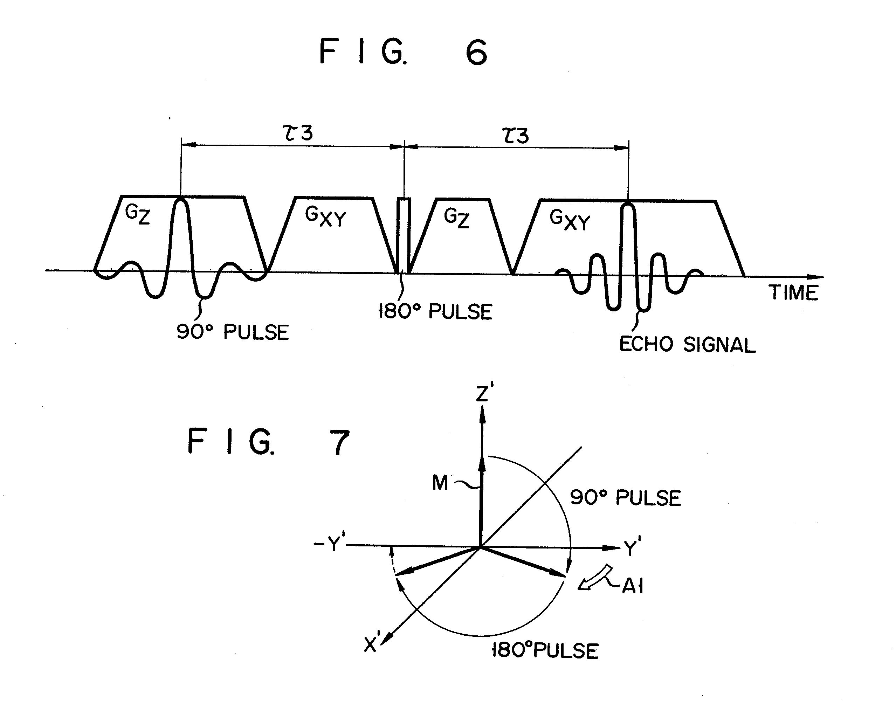

Fig. 6 shows a pulse sequence diagram how to acquire an echo signal according to one preferred embodiment;

Fig. 7 is a schematical illustration for explaining the macromatic magnetization vector with respect to
Fig. 6;

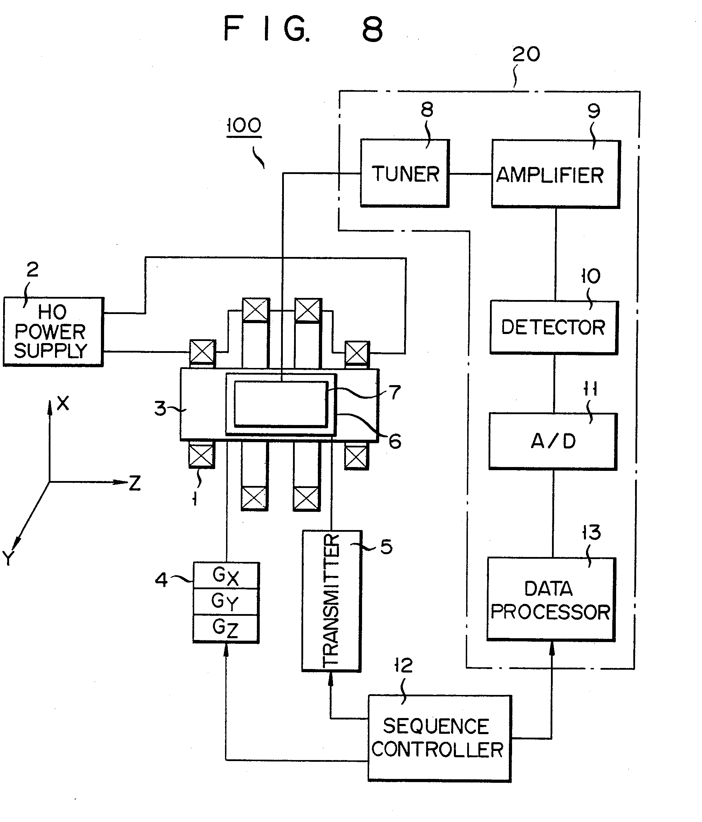

Fig. 8 shows a block diagram of the diagnostic
NMR-CT apparatus in which the principle of the invention
is introduced; and

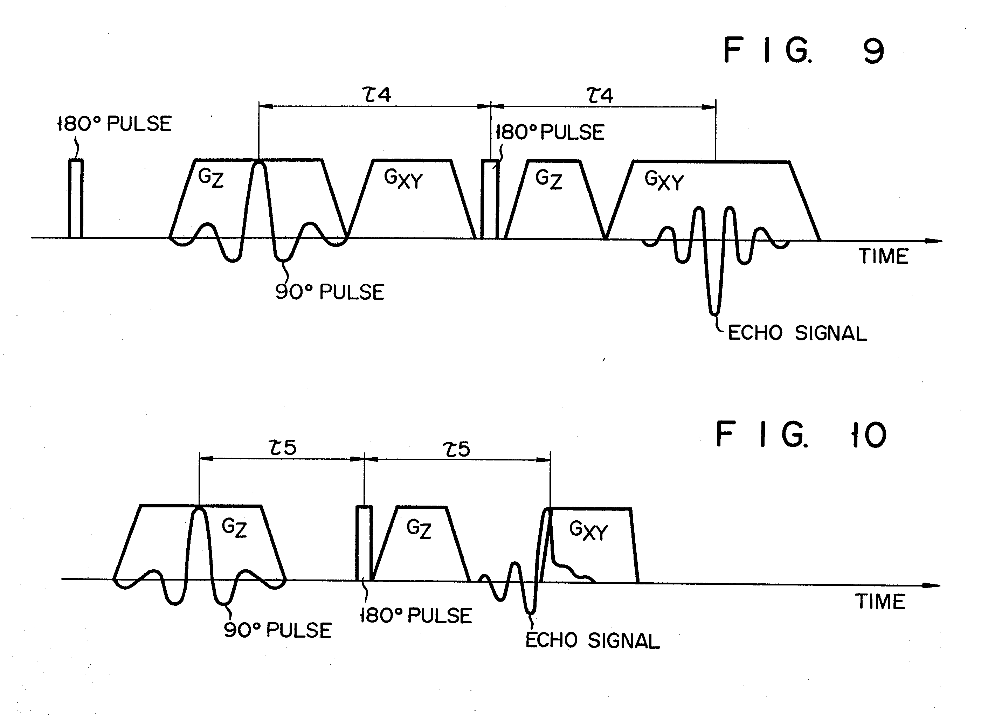

Figs. 9 and 10 show pulse sequence diagrams how to
acquire echo signals according to another embodiment
respectively.

Before proceeding with the various types of the
preferred embodiments, a basic operation of the
apparatus according to the present invention will now be
explained.

The phase difference in the gyroscopic precession
of the nucleus can be compensated in such a manner that
the gradient magnetic field having the same polarity as
that of the gradient magnetic field for determining the
slice position is applied to the slice after the slice
positioned is first determined and then the 180° pulse
is applied. Thereafter the echo signal can be obtained.

Fig. 6 shows a pulse sequence according to an
embodiment of the present invention. The pulse sequence
shown in Fig. 6 corresponds to that shown in Fig. 4.

However, the case of Fig. 6 is different from that
shown in Fig. 4 in the following respect. Unlike the
case shown in Fig. 4 wherein the gradient magnetic field
(referred to as "gradient field") $-G_Z$ is applied after
simultaneous application of the gradient field $G_Z$ and
the 90° pulse, the gradient field $G_Z$ (of the same
polarity as that of the initial gradient field $G_Z$) is
reapplied for phase difference cancellation after the
180° pulse is applied.

Fig. 7 shows the macroscopic magnetization vector
"M" in this case. The coordinate system shown in Fig. 7
corresponds to that shown in Fig. 5.

As in the case shown in Fig. 7, when the initial
gradient field $G_Z$ of the positive polarity (= initial
first gradient field) is applied together with the 90° pulse, the magnetization vector "M" in a static field $H_1$ stronger than the static field $H_0$ is shifted from the Y'-axis in the direction indicated by arrow Al to be included in the plane X'-Y'. However, in this embodiment, when the 180° pulse is then applied, the vector "M" is rotated through 180° (-Y'-X' plane) around the X'-axis. Therefore, in order to cancel the phase difference, the gradient field $G_Z$ of the same polarity as that of the initial first gradient field $G_Z$ (the gradient field for determining the slice) applied together with the 90° pulse is reapplied. However, in this case, the vector "M" is redirected along the negative direction (-Y'-axis) of the Y'-axis. The magnetization vector "M" in a static field $H_2$ weaker than that of the static field $H_0$ is similarly redirected along the negative direction of the Y'-axis.

The static fields $H_1$ and $H_2$ will now be described more in detail. When the correlation between the static field $H_0$ and the gradient field $G_Z$ is considered, a resonant angular frequency at the cross point of the static field $H_0$ and the gradient field $G_Z$ is represented by $\omega_0$. The resonant angular frequency becomes $\omega_1$ in the static field $H_1$ stronger than the field $H_0$, and becomes $\omega_2$ in the static field $H_2$ weaker than the field $H_0$. Therefore, the relation $\omega_1 > \omega_0 > \omega_2$ is established in accordance with the slice position. Since there is also a relation $H_1 > H_0 > H_2$, the magnetization vector "M" behaves in the manner as described above since the resonant angular frequencies are different from each other depending upon the slice position. A second gradient magnetic field (referred to as "second gradient field") $G_{XY}$ is applied to determine a projection direction of an echo signal to be acquired.

The nucleus density data is mainly obtained from the echo signal.

In this manner, the phase difference can be corrected by a first gradient field $G_Z$ of a single polarity. In comparison with the case of Fig. 4, the time required therein for an application of the gradient field $-G_Z$ can be omitted, thus resulting in a decrease in the total processing time (time period $\tau_2 > \tau_3$).

In general, the shorter a time period "$\tau$" becomes, the greater an S/N ratio of an acquired echo signal is improved. Since the echo signal is attenuated within a time period determined by T2, it must be collected as quickly as possible.

Fig. 8 shows a construction of an embodiment of an NMR-CT diagnostic apparatus utilizing the sequence control operation as described above. It should be noted that the sequence control operation according to the invention may be realized by the circuit elements 1 through 7 and 12 as shown in Fig. 8.

Referring to Fig. 8, a static field coil 1 applies a static field $H_0$ to an object when under investigation (not shown) excited by a static field power supply 2 (referred to as "$H_0$ power supply"). A gradient magnetic field coil (referred to as "gradient field coil") 3 comprises a combination of three coils for generating gradient magnetic fields along the X-, Y- and Z-axes so as to apply first and second gradient magnetic fields "$G_Z$" and "$G_{XY}$" as superposed on the static field $H_0$. In this embodiment, the longitudinal axis of the object (not shown) is defined as the Z-axis. A gradient field power supply 4 comprises three power supplies for energizing the coil 3 along the X-, Y- and Z-axes in three pairs of the gradient magnetic fields $G_Z$, $G_{XY}$; $G_X$, $G_{ZY}$; $G_Y$, $G_{ZX}$. A transmitter 5 can time-sequentially transmit a 90° pulse signal and a 180° pulse signal selectively. Based on the signal transmitted by the transmitter 5, an RF field coil or a transmitter coil 6 applies a 90° pulse or a 180° pulse to the object. A receiver coil 7 receives an NMR signal (an echo signal in this embodiment) induced in the object. A tuner 8 constitutes a tuning circuit together with the receiver

- 11 -                    0124096

coil 7, and detects the received echo signal.  A detector 10 detects the echo signal received through an amplifier 9.  An A/D converter (analog-to-digital converter) 11 converts the detection output from the detector 10 into digital data.  A sequence controller 12 controls the various components so as to properly generate the 90° pulse, the 180° pulse, and the first and second gradient fields $G_Z$ and $G_{XY}$, and to determine the signal reception timing and intervals in accordance with the pulse sequence shown in Fig. 6.  A data processor 13 performs an image reconstruction based on the echo signal data from the A/D converter 11 so as to obtain image data.  The above-described tuner 8, amplifier 9, detector 10, A/D converter 11, and data processor 13 constitute an NMR signal processing device 20 that is connected to the receiver coil 7 so as to produce the tomographic image on the slice of the object.  The operation timing, sequence and the like of the data processor 13 are also controlled by the sequence controller 12.  As has been described above, the section of the gradient field power supply 4 for generating the gradient field $G_Z$ along the Z-axis can comprise a single channel power supply.  In the embodiment described above, the transmitter and receiver coils 6 and 7 are separated from each other to provide a probe head.  However, a probe head of a single coil type may be used wherein a single coil serves for both functions.

The operation of the NMR-CT diagnostic apparatus shown in Fig. 8 will now be described with reference to the waveform charts shown in Fig. 6.

A static field $H_0$ of a predetermined intensity is continued to be applied to an object (not shown) by the $H_0$ power supply 2.  The direction of the field $H_0$ is along the Z-axis, that is, along the longitudinal axis of the object.  In order to determine a slice in the object, the gradient field power supply 4 is energized to apply to the object an initial first gradient field

$G_Z$ of a predetermined intensity and polarity (positive polarity in this embodiment) through the gradient field coil 3 along the Z-axis, i.e., the longitudinal axis of the object. Then, the static field $H_0$ is superposed on the initial first gradient field $G_Z$ during the given time period "$\tau_3$". In synchronism with the application of the field $G_Z$, the 90° pulse (RF exciting pulse) is applied to the object by the transmitter 5 through the transmitter coil 6. Then, a specific nucleus in the selected slice is excited; for example, protons resonate in response to the 90° pulse. As previously described, the central resonant angular frequency is represented by $\omega_0$, and there are also frequency components at frequencies $\omega_1$ and $\omega_2$ which are shifted from the frequency $\omega_0$ by a predetermined frequency. Upon application of the 90° pulse, the macroscopic magnetization vector "M" is shifted toward the Y'-axis of the rotated coordinate system (see Fig. 7).

When the second gradient field $G_{XY}$ is applied next by the same power supply 4 as in the first gradient field $G_Z$, the vector "M" which has been converged on the Y'-axis is dispersed. Subsequently, the 180° pulse (RF exciting pulse) is applied to the object by the transmitter 5 so as to rotate the magnetization vector M around the X'-axis (see Fig. 7). The time period between the center point of the 90° pulse and that of the 180° pulse is represented by τ3.

After the 180° pulse is applied, the first gradient field $+G_Z$ for determining the slice is again applied. Then, the magnetization vector "M" in the -X'-Y' plane is shifted to be directed along the -Y'-axis. In this case, the application time and intensity of the first gradient field $+G_Z$ applied for a second time are determined to be half those of the initial application thereof to obtain a prescribed effect. Then, the second gradient field $G_{XY}$ is again applied so as to reconcentrate the dispersed magnetization vector "M" along the Y'-axis and to determine the projection direction of the echo signal. After time period τ4 since the application of the 180° pulse, the echo signal is obtained at the tuner 8 through the receiver coil 7.

The echo signal obtained in this manner is amplified, detected and A/D converted to provide a digital echo signal. In this embodiment, the digital echo signal is subjected to a predetermined reconstruction process to obtain tomographic image data of the slice of the object.

It is to be noted that the signal processing of tuning, amplification, detection, and the A/D conversion and image construction described above are not limited to the methods exemplified above and must not be construed as being so limited.

The series of sequence control as described above is performed in accordance with a predetermined program.

With the construction described above, correction of the phase difference in the gyrosopic precession by the pulse sequence shown in Fig. 6 can be performed, and the following effects are obtained.

(a) The manufacturing cost of the gradient field power supply 4 can be significantly reduced.

(b) The cancelling precision of the phase difference can be improved, and an image of good quality is obtained.

(c) The overall configuration and control sequence are simplfied, and the control system and software are also simplified.

(d) With such a simplification in the configuration and control sequence, adjustment can be simplified, and the stability of the apparatus is improved.

(e) The diagnostic time can be shortened.

(f) Due to the effects of items (a) to (e) above, the cost performance ratio of the overall apparatus can be drastically improved.

The second embodiment of the present invention will now be described with reference to Fig. 9. In this embodiment, the means for executing the sequence control shown in Fig. 9 is known and can be realized with the configuration shown in Fig. 8, and therefore will briefly be described.

At first a 180° pulse (RF exciting pulse) is applied to the object by a transmitter 5. In this case, a static field $H_0$ is being applied to the object by the $H_0$ power supply 2. The direction of an application of the field $H_0$ is the same as that in the first embodiment. Then, the initial first gradient field $G_Z$ and a 90° pulse are simultaneously applied, and thereafter a second gradient field $G_{XY}$ and a 180° pulse are subsequently applied. Thereafter, another first gradient field $G_Z$ is applied as a characteristic feature of the present invention; in other words, is applied another gradient field $G_Z$ of the same polarity as that of the initial gradient field $G_Z$ for determining the slice. Another second gradient field $G_{XY}$ is then applied to determine the projection direction of an echo signal by a receiver coil 7. Since the 180° pulse is applied twice, the phase of the resultant echo signal is shifted by 180°, that is, inverted with respect to that obtained in the first embodiment. A time period "$\tau 4$" is shortened with respect to the corresponding time period for the pulse sequence of the prior art apparatus. In this embodiment, the "T1" (spin-lattice relaxation time) data and the nucleus density data are mainly obtained.

The third embodiment of the present invention will now be described with reference to Fig. 10. The pulse sequence in this case corresponds to the spin-echo sequence shown in Fig. 3. While a 90° pulse is applied, the initial first gradient field $G_Z$ is simultaneously applied. However, the field $-G_Z$ is not applied thereafter as previously described.

Alternatively, another gradient field $G_Z$ of the same polarity is applied after an application of a 180° pulse so as to obtain an echo signal. After applying the 180° pulse for a time period equal to time period $\tau 5$ between the applications of the 90° pulse and the 180° pulse, the echo signal is obtained. The time period $\tau 5$ is shorter than the time period $\tau 1$ shown in Fig. 3.

Since the second gradient field $G_{XY}$ is being applied during a collection of the echo signal, the amplitude of the echo signal is abruptly reduced. In this embodiment, the T2 (spin-spin relaxation time) data and the nucleus density data are mainly obtained.

The present invention is not limited to the particular embodiments described above, and various changes and modifications may be made within the spirit and scope of the present invention.

For example, in the embodiment shown in Fig. 6, the slice is included in the X-Y plane perpendicular to the Z-axis (direction of the static field $H_0$) in the description of the gradient field $G_Z$. However, the correction of the phase difference can be performed by a pulse sequence with a gradient magnetic field along any of the X-, Y- and Z-axes.

It is also possible to omit the second gradient magnetic field "$G_{XY}$" from the pulse sequences shown Figs. 6 and 9 so as to produce the echo signal. In this case, the total time required for acquiring the echo signal can be further shortened, but the amplitude of the acquired echo signal becomes relatively small.

Claims:

1.    An apparatus for measuring a nuclear magnetic resonance signal, comprising:

means (1; 2) for applying uniformly a static magnetic field ($H_0$) to an object under investigation;

means (3; 4) for applying at least a first gradient magnetic field ($G_Z$; $G_X$; $G_Y$) to the object in a direction perpendicular to a slice of the object so as to determine a slice position of the object;

signal transmitter means (5; 6) through which first and second exciting pulses are selectively applied to the object so as to excite the slice of the object in conjunction with the static and first gradient magnetic fields, whereby the nuclear magnetic resonance signal is induced in the slice of the object;

signal receiver means (7) through which the nuclear magnetic resonance signal is received;

sequence control means (12) for performing sequence control operations of at least the means for applying the first gradient magnetic field, and the signal transmitter means in such a manner that after the first exciting pulse and the first gradient magnetic field are simultaneously applied to excite and determine the slice of the object under the influence of the static magnetic field, another gradient magnetic field having the same polarity as that of the first gradient magnetic field is applied to the slice of the object immediately after the second exciting pulse is applied thereto.

2.    An apparatus as claimed in claim 1, characterized in that,

the means (3; 4) for applying the first gradient magnetic field ($G_Z$; $G_X$; $G_Y$) further applies a second gradient magnetic field ($G_{XY}$; $G_{ZY}$; $G_{ZX}$) in such a manner that under the control of the sequence control means (12), after the simultaneous application of the first gradient magnetic field ($G_Z$; $G_X$; $G_Y$) and the first exciting pulse, the second gradient magnetic field ($G_{XY}$; $G_{ZY}$; $G_{ZX}$) is applied just before an application of the second exciting pulse and also immediately after an application of said another gradient magnetic field ($G_Z$; $G_X$; $G_Y$).

3. An apparatus as claimed in claim 1, characterized in that,

the means (3; 4) for applying the first gradient magnetic field ($G_Z$; $G_X$; $G_Y$) further applies a second gradient magnetic field ($G_{XY}$; $G_{ZY}$; $G_{ZX}$) in such a manner that under the control of the sequence control means (12), after the simultaneous application of the first gradient magnetic field ($G_Z$; $G_X$; $G_Y$) and the first exciting pulse, the second gradient magnetic field ($G_{XY}$; $G_{ZY}$; $G_{ZX}$) is applied during occurence of the nuclear magnetic resonance signal.

4. An apparatus as claimed in claim 1, characterized in that,

the first and second exciting pulses are 90° and 180° exciting pulses respectively.

5. A diagnostic NMR-CT apparatus (100) comprising:

means (1; 2) for applying uniformly a static magnetic field to an object under investigation;

means (3; 4) for selectively applying to the object a first gradient magnetic field ($G_Z$; $G_X$; $G_Y$) in a direction perpendicular to a slice of the object, and a second gradient magnetic field in a direction parallel to the slice of the object;

signal transmitter means (5; 6) through which first and second exciting pulses are selectively applied to the object so as to excite the slice of the object in conjunction with the static, first and second gradient magnetic fields, whereby the nuclear magnetic resonance signal is induced in the slice of the object;

signal receiver means (7) through which the nuclear magnetic resonance signal is received;

means (20) for processing the nuclear magnetic resonance signal that is received from the signal receiver means (7); and

sequence control means (12) for performing sequence control operations of at least the means for applying the first and second gradient magnetic fields, the signal transmitter means, and the processing means in such a manner that after the first exciting pulse and the first gradient magnetic field are simultaneously applied to excite and determine the slice of the object under the influence of the static magnetic field, another gradient magnetic field having the same polarity as that of the first gradient magnetic field is applied to the slice of the object immediately after the second exciting pulse is applied thereto, whereby the nuclear magnetic resonance signal is processed in the processing means so as to obtain an NMR-CT image on the slice of the object.

6. An apparatus as claimed in claim 5, characterized in that,

the processing means (20) includes;

a tuner (8) which is coupled to the signal receiver means (7) so as to receive the nuclear magnetic resonance signal under the tuning condition;

an amplifier (9) for amplifying the tuned nuclear magnetic resonance signal to a given signal level;

a detector (9) for detecting the amplified nuclear magnetic resonance signal;

an A/D converter (11) for converting the detected nuclear magnetic resonance signal into a corresponding digital nuclear magnetic resonance signal; and

a data processor (13) for performing image reconstruction processing to the digital nuclear magnetic resonance signal, thereby obtaining the NMR-CT image on the slice of the object under the control of the sequence control means (12).

7. An apparatus as claimed in claim 5, characterized in that,

- 4 -                    0124096

the detector is a quadrature phase detector.

8.   An apparatus as claimed in claim 5, characterized in that,

the first and second exciting pulses are 90° and 180° exciting pulses respectively.

# F I G. 1

INTERVAL NUMBER / TIME ——→ / REPEATED FID SEQUENCE

# F I G. 2

| 180° PULSE | 90° PULSE | 180° PULSE |

AMPLITUDE OF RF FIELD

$G_Z$ GRADIENT

$(+)G_Z$

$(-)G_Z$

$G_{XY}$ GRADIENT

SIGNAL

FID SIGNAL

INTERVAL NUMBER

| 1 | 2 | 3 | 4 | 5 | 6 | 1 |

TIME ⟶

INVERSION-RECOVERY SEQUENCE

2/7

0124096

0124096

# FIG. 3

# FIG. 4

GZ, GXY, GXY, GZ, -GZ

90° PULSE

180° PULSE

ECHO SIGNAL

$\tau_2$  $\tau_2$

TIME

# FIG. 5

M, z', x', Y', A2, A1

90° PULSE

# F I G. 6

τ3

τ3

Gz

Gxy

180° PULSE

Gz

Gxy

TIME

90° PULSE

ECHO SIGNAL

# F I G. 7

Z'

M

90° PULSE

-Y'

Y'

A1

X'

180°PULSE

F I G. 8

F I G. 9

180° PULSE

τ4          τ4

180° PULSE

G_Z     G_{XY}          G_Z     G_{XY}

TIME

90° PULSE

ECHO SIGNAL

F I G. 10

τ5          τ5

G_Z          G_Z          G_{XY}

TIME

90° PULSE     180° PULSE     ECHO SIGNAL